**Europäisches Patentamt**

(19) **European Patent Office**

**Office européen des brevets**

(11) Veröffentlichungsnummer: **0 142 106**
**B1**

(12) **EUROPÄISCHE PATENTSCHRIFT**

(45) Veröffentlichungstag der Patentschrift:
**19.04.89**

(51) Int. Cl.⁴: **H 01 J 37/21,** H 01 J 37/26,
G 02 B 7/11

(21) Anmeldenummer: **84113193.1**

(22) Anmeldetag: **02.11.84**

(54) **Verfahren und Einrichtung zum Ermitteln des Fokussierungszustandes eines abbildenden optischen Gerates.**

(30) Priorität: **04.11.83 DE 3340009**

(43) Veröffentlichungstag der Anmeldung:
**22.05.85 Patentblatt 85/21**

(45) Bekanntmachung des Hinweises auf die Patenterteilung:
**19.04.89 Patentblatt 89/16**

(84) Benannte Vertragsstaaten:
**DE FR GB IT NL**

(56) Entgegenhaltungen:
**EP-A-0 017 726**
**US-A-4 025 949**

**OPTICS COMMUNICATIONS, Band 41, no. 6, Mai 1982, AMSTERDAM (NL), pp. 411-416, V.I. VLAD: "Opto-electronic bistable devices in real-time optical information processing"**
**ZEITSCHRIFT FÜR NATURFORSCHUNG, Band 29A, Nr. 12, 1974, pp. 1931-1932, TÜBINGEN (DE), W. HOPPE et al.: "Light optical convolution computers in electron microscopy"**

(73) Patentinhaber: **Max- Planck- Gesellschaft zur Förderung der Wissenschaften e.V., Bunsenstrasse 10, D-3400 Göttingen (DE)**

(72) Erfinder: **Hoppe, Walter, Prof. Dr., Ahornstrasse 5, D-8032 Lochham (DE)**

(74) Vertreter: **von Bezold, Dieter, Dr., Dr. Dieter von Bezold Dipl.- Ing. Peter Schütz Dipl.- Ing. Wolfgang Heusler Brienner Strasse 52, D-8000 München 2 (DE)**

## Beschreibung

Die vorliegende Erfindung betrifft ein Verfahren und Einrichtungen zum Ermitteln des Fokussierungszustandes eines abbildenden Gerätes, wie eines Licht- oder Elektronenmikroskopes.

Das Hauptanwendungsgebiet der Erfindung sind Elektronenmikroskope, insbesondere Durchstrahlungs-Elektronenmikroskope, und die Erfindung soll daher im folgenden in erster Linie anhand dieses Anwendungsbeispieles erläutert werden. Dies ist jedoch nicht einschränkend auszulegen, die Erfindung läßt sich vielmehr auch auf andere abbildende teilchenoptische Geräte, wie Ionenmikroskope, Bildwandler und dergl., anwenden sowie auch auf abbildende lichtoptische Geräte, wie Lichtmikroskope.

Der Fokussierungszustand ("Scharfeinstellung") eines Elektronenmikroskopes wird im allgemeinen visuell anhand des Leuchtschirmbildes eingestellt. Es ist auch bereits aus der DE-C-2 441 288 bekannt, den Fokussierungszustand eines Elektronenmikroskops durch Kreuzkorrelation zu bestimmen. Weiterhin ist aus der EP-A-17 726 ein Verfahren zur automatischen Scharfeinstellung eines jeden Bildpunktes eines mittels eines Objektives beobachteten Bildes bekannt, bei dem u. a. von der berechneten Autokorrelationsfunktion der Helligkeitsverteilung des Bildes an einer bestimmten Stelle der Mittelwert der Autokorrelationsfunktion abgezogen und durch den Mittelwert der Autokorrelationsfunktion im Bild dividiert wird. Das Maximum der so gewonnen normierten Funktion wird dann iterativ aufgesucht indem die Schärfeeinstellung des Objektives entsprechend eingestellt wird. In allen diesen Fällen kann man das Vorzeichen einer Defokussierung nicht aus einem einzigen Bild, also aus einer "Momentaufnahme" bestimmen, man muß vielmehr den fokussierungszustand ändern, um feststellen zu können, ob das Elektronenmikroskop überfokussiert oder unterfokussiert ist. Bei einer überfokussierung liegt die Fokusebene, d. h. die Ist-Ebene des fokussierten Bildes, vom Objekt aus gesehen vor der Soll-Bildebene, z. B. einem Leuchtschirm, einer Photoplatte, einer Photokathode eines Bildwandlers oder der Objektebene eines Okulars eines lichtoptischen Mikroskopes, während bei einer Unterfokussierung sich die Fokusebene hinter der Soll-Bildebene befindet.

Aus der US-A-4 025 949 ist ein Fehlerkorrektursystem für einen mit optischer Abtastung arbeitenden Plattenspieler bekannt, bei dem durch zwei im Abstand voneinander angeordnete, gekreuzte Zylinderlinsen zwei strichförmige Bilder einer punktförmige Lichtquelle mit Abstand längs des Strahlenganges erzeugt werden und die Lage dieser Bilder längs des Strahlenganges ermittelt wird. Mit einem Bild eines flächigen Objekts läßt sich dieses Verfahren nicht durchführen, es arbeitet auch nicht auf dem Prinzip der Bildkorrelation sondern auf dem Prinzip der Verschiebung der Lage eines optischen Bildes längs des Strahlenganges, ganz abgesehen davon, daß es sich bei diesem Stand der Technik nicht um ein bilderzeugendes Gerät handelt.

Der vorliegenden Erfindung liegt die Aufgabe zugrunde, ein Verfahren und eine Einrichtung anzugeben, durch die das Vorzeichen und gemäß einer Weiterbildung auch der Betrag der Defokussierung des Gerätes auf einfache Weise bestimmt werden kann.

Diese Aufgabe wird bei einem Verfahren zum Ermitteln des Fokussierungszustandes eines teilchenoptischen bilderzeugenden Gerätes, wie eines Elektronenmikroskops, dessen Strahlengang eine Vorrichtung zur Beeinflussung des axialen Astigmatismus des erzeugten Bildes enthält, gemäß der Erfindung dadurch gelöst, daß damit ein axialer Astigmatismus vorgegebener Orientierung erzeugt wird, daß die in zwei verschiedenen Bildebenen entstehenden astigmatischen Bilder in zeitabhängige Signale umgewandelt und anschließend diese Signale direkt oder durch Umwandlung in optische Muster und anschließende optische Korrelation unter Erzeugung einer zweidimensionalen Korrelationsfunktion korreliert werden und daß die Orientierung der Korrelationsfunktion bestimmt wird.

Bei einem Verfahren zum Ermitteln des Fokussierungszustandes eines lichtoptischen bilderzeugenden Gerätes, wie eines Lichtmikroskops, wird diese Aufgabe dadurch gelöst, daß eine Vorrichtung zur Beeinflussung des axialen Astigmatismus des erzeugten Bildes vorgesehen ist, daß damit ein axialer Astigmatismus vorgegebener Orientierung erzeugt wird, daß die in zwei verschiedenen Bildebenen entstehenden astigmatischen Bilder in zeitabhängige Signale umgewandelt und anschließend diese Signale direkt oder durch Umwandlung in optische Muster und anschließende optische Korrelation unter Erzeugung einer zweidimensionalen Korrelationsfunktion korreliert werden, und daß die Orientierung der Korrelationsfunktion bestimmt wird.

Die beiden astigmatischen Bilder können gleich sein und unter Bildung der Autokorrelationsfunktion korreliert werden.

Um den Betrag der Defokussierung zu bestimmen, wird ein bestimmter Betrag des Astigmatismus eingestellt und der Betrag der Defokussierung wird aus der Längsabmessung des aus der Korrelationsfunktion resultierenden Korrelations-Peaks bestimmt.

Eine teilchenoptische Einrichtung, wie ein Elektronenmikroskop, die ein Abbildungssystem, welches eine Soll-Bildebene und eine Vorrichtung zur Beeinflussung des axialen Astigmatismus eines in der Soll-Bildebene erzeugten Bildes enthält, und eine Korrelationsvorrichtung, der eine dem Bild entsprechende Eingangsgröße zugeführt ist, aufweist, ist gemäß der Erfindung dadurch gekennzeichnet, daß die Korrelationsvorrichtung eine Anordnung zum Ermitteln der Orientierung eines länglichen Korrelations-Peaks enthält.

Eine lichtoptische Einrichtung mit einem Abbildungssystem zum Erzeugen eines Bildes in einer Soll-Bildebene und mit einer Korrelationsvorrichtung, der eine dem Bild entsprechende Eingangsgröße zugeführt ist, um einen Korrelationspeak zu erzeugen, ist erfindungsgemäß dadurch gekennzeichnet, daß das Abbildungssystem eine Vorrichtung zur Beeinflussung des axialen Astigmatismus des erzeugten Bildes enthält und daß die Korrelationsvorrichtung eine Anordnung zum Ermitteln der Orientierung des infolge des eingeführten Astigmatismus länglichen Korrelations-Peaks enthält.

Die Korrelationsvorrichtung kann eine Autokorrelationsvorrichtung sein.

Die Korrelationsvorrichtung kann ein optischer Korrelator sein, der Flüssigkristallmatrixanordnungen zum Erzeugen optischer Darstellungen des Bildes enthalten kann.

Vorteilhafterweise enthält die erfindungsgemäße Einrichtung eine Steuervorrichtung, die bei Auslösung einen vorgegebenen axialen Astigmatismus bestimmter Orientierung erzeugt und anschlienend die Ermittlung der Orientierung des Korrelations-Peaks veranlaßt. Ein der Orientierung des Korrelations-Peaks entsprechendes Signal kann einer Vorrichtung zur Nachstellung des Fokussierungszustandes zugeführt sein.

Durch das vorliegende Verfahren und die vorliegende Erfindung lassen sich das Vorzeichen und gegebenenfalls der Betrag der Defokussierung aus einem einzigen Bild einwandfrei bestimmen und damit die Richtung einer etwa notwendigen axialen Verstellung des Objekts, des Mikroskoptubus oder der Änderung von Linsenströmen bzw. Spannungen, die für die Erzeugung eines elektronenoptischen fokussierten Bildes in der Soll-Bildebene erforderlich ist. Han kann dadurch den Fükussierungsprozeß leicht automatisieren.

Im folgenden werden bevorzugte Ausführungsbeispiele der Erfindung unter Bezugnahme auf die Zeichnungen näher erläutert.

Es zeigen:

Fig. 1  eine schematische Darstellung eines Durchstrahlungs-Elektronenmikroskops mit einer Ausführungsform einer Einrichtung zur Durchführung des vorliegenden Verfahrens;

Fig. 2  Darstellungen der Autokorrelationsfunktion eines astigmatischen Bildes für verschiedene Fokussierungszustände;

Fig. 3a  und 3b Logikschaltnetze für eine Einrichtung gemän Fig. 1.

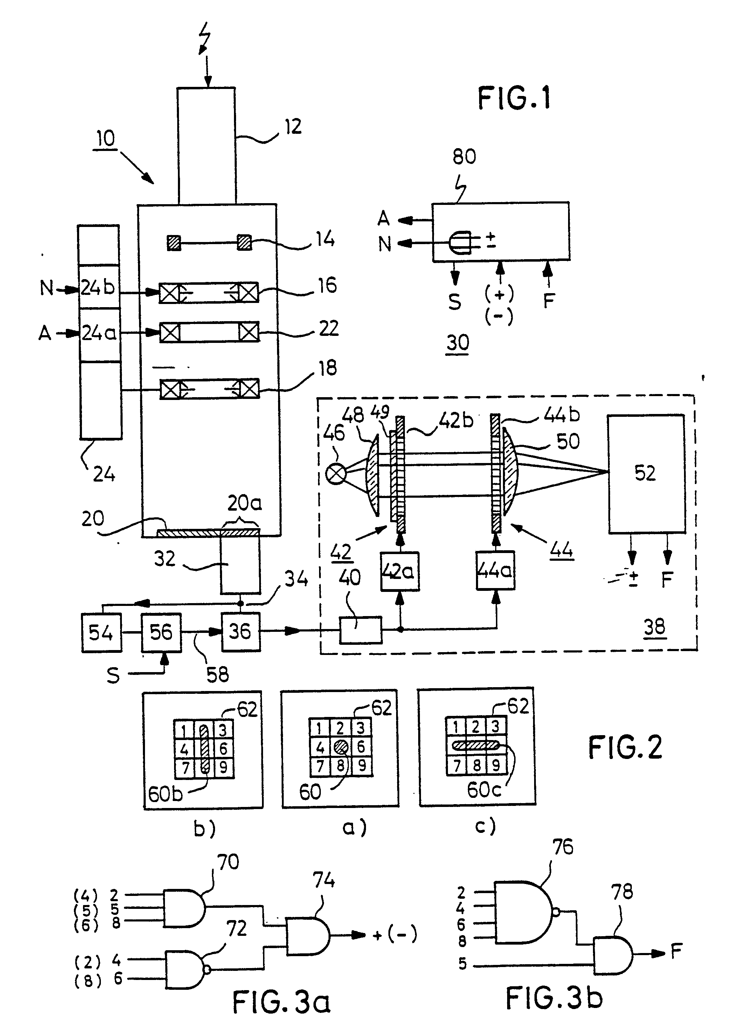

In Fig. 1 ist ein im wesentlichen konventionelles elektromagnetisches Durchstrahlungs-Elektronenmikroskop 10 dargestellt, welches ein Strahlerzeugungssystem 12, eine Objekthalterung 14, ein Objektiv 16, ein Projektiv 18 und einen Leuchtschirm 20 enthält. Der Strahlengang des Elektronenmikroskops 10 enthält ferner einen Stigmator 22, der hinter dem Objektiv 16 angeordnet ist. Ein Stigmator ist eine magnetische Multipollinse, die zur Kompensation des axialen Astigmatismus des Abbildungssystems dient. Unter dem axialen Astigmatismus versteht man den Bildfehler der durch Abweichungen des elektronenoptischen Linsensystems von der Rotationssymmetrie verursacht wird, und wenn hier von "Astigmatismus" oder "astigmatisch" gesprochen wird, ist immer der axiale Astigmatismus gemeint. Die verschiedenen elektromagnetischen Linsen werden durch eine geregelte Stromversorgungseinheit 24 gespeist. Dem Elektronenmikroskop 10 ist eine Einrichtung 30 zur Bestimmung des Fokussierungszustandes zugeordnet. Die Einrichtung 30 enthält bei dem Ausführungsbeispiel gemäß Fig. 1 eine optisch-elektrische Wandlereinrichtung 32, die nach Art einer Fernsehkamera aufgebaut sein kann und einen Teil 20a des Leuchtschirms 20 rastermäßig abtastet sowie auf einer Ausgangsleitung 34 ein fernsehmäßiges Videosignal liefert. Das Videosignal von der Ausgangsleitung 34 wird über eine Torschaltung 36 einem optischen Korrelator 38 zugeführt, der die Autokorrelationsfuktion des von der Wandlereinrichtung 32 erfaßten Bildbereiches erzeugt. Bei der dargestellten Ausführungsform enthält der optische Korrelator 38 eine Schwellenwertschaltung 40, die die Amplitude der Videosignale binär quantisiert, sowie zwei Flüssigkristall-Punktmatrix-Anzeigevorrichtungen, die jeweils eine Steuerschaltung 42a, 44a sowie eine zweidimensionale Flüssigkristallzellenanordnung 42b, 44b, enthalten. Solche LCD-Anzeigevorrichtungen sind im Handel erhältlich, siehe z. B. den Bericht "Grafik-LCD" in der Zeitschrift FUNKSCHAU 12/1982, S. 12. Der optische Korrelator enthält ferner eine Lichtquelle 46 und eine Kondensorlinse 48 und eine Streuscheibe 49 zum Beleuchten der LCD-Punktmatrix 42b, eine Linse 50 zur Fokussierung der parallelen Lichtstrahlen, die entsprechende Bildelemente (Pixels) in den Punktmatrix-Anzeigevorrichtungen 42b, 44b durchsetzen, und eine optisch-elektrische Wandlereinrichtung 52, die beispielsweise eine zweidimensionale Anordnung von Photodioden enthalten kann und anhand von Fig. 2 und 3 noch näher erläutert werden wird. Das Prinzip des Optischen Korrelators 38 und anderer geeigneter optischer Korrelatoren ist in DE-C-2 441 288 und DE-C-2 529 735 eingehend beschrieben, auf die hier ausdrücklich Bezug genommen wird. Optische Korrelatoren mit LCD-Einrichtungen sind in DE-A-3 325 855 beschrieben, auf die hier ebenfalls Bezug genommen wird.

Der optische Korrelator 38 kann auf dem Prinzip der Kreuzkorrelation arbeiten, wie die oben beschriebenen bekannten bzw. vorgeschlagenen optischen Korrelatoren, vorzugsweise arbeitet er jedoch auf dem Prinzip der Autokorrelation, d. h. daß ein durch die elektro-optische wandlereinrichtung 32 aufgenommenes Bild mit sich selbst korreliert wird, was mathematisch einer Quadrierung der Intensitäten der einzelnen Pixels und Summierung der erhaltenen Quadrate entspricht. Die Autokorrelation hat gegenüber der Kreuzkorrelation den Vorteil, daß das in der Bildebene der Linse 50 auf der optischelektrischen Wandlereinrichtung 52 entworfene Bild der Korrelationsfunktion oder Faltung immer zentriert ist.

Die Eingabe eines einzigen Bildes in den optischen Korrelator 38 kann auf verschiedene Weise erfolgen. Bei dem dargestellten Ausführungsbeispiel werden die Videosignale von der Ausgangsleitung 34 einer Vertikalsynchronisierimpuls-Abtrennstufe 54 zugeführt, von der die abgetrennten Vertikalsynchronisierimpulse einer Zählerschaltung 56 zugeführt werden. Die Zählerschaltung 56 ist durch einen Startimpuls S einschaltbar und liefert auf einer Ausgangsleitung 58 einen Auftastimpuls an die Torschaltung 36, der beginnt, wenn der erste Vertikalsynchronisierimpuls eintrifft, nachdem die Zählerschaltung durch den Startimpuls ansprechbereit gemacht worden ist und der endet, wenn der dritte Vertikalsynchronisierimpuls eintrifft. Auf diese Weise läßt die Torschaltung 36 also genau zwei Halbbilder durch, die durch die Schwellenwertschaltung 40 quantisiert und durch die LCD-Anzeigevorrichtungen 42, 44 in entsprechende Transmissionsbilder umgesetzt werden.

Die Autokorrelationsfunktion eines stigmatisch fokussierten Bildes ist ein rotationssymmetrischer Peak 60, wie er in Fig. 2a dargestellt ist. Enthält die optisch-elektrische Wandlereinrichtung 52 beispielsweise eine Matrix von 3 x 3 Photodioden 1 bis 9, wie es in Fig. 2a dargestellt ist, und ist die Photodioden-Matrix bezüglich des Strahlenganges des Korrelators 38 zentriert, so erhält bei einem stigmatisch fokussierten Bild lediglich die mittlere Photodiode 5 Licht. Die Verhältnisse ändern sich auch nicht wesentlich, wenn das Bild mit axialem Astigmatismus behaftet ist. Die Autokorrelationsfunktion ist bei fokussiertem Bild dann immer noch rotationssymmetrisch, das Autokorrelationsmaximum ist lediglich etwas diffuser.

Anders liegen die Verhältnisse jedoch, wenn das durch das elektronenoptische System erzeugte astigmatische Bild nicht in der durch den Leuchtschirm 20 gebildeten Soll-Bildebene liegt. In diesem Falle ist das Bild der Autokorrelationsfunktion des astigmatischen Bildes ein langgezogener, strichartiger bzw. ellipsenförmiger Peak, der in Abhängigkeit von der Orientierung des axialen Astigmatismus des Abbildungssystems und je nachdem, ob Überfokussierung oder Unterfokussierung vorliegt, eine erste, z. B. vertikale Richtung hat, wie es in Fig. 2b dargestellt ist, oder eine im rechten Winkel hierzu verlaufende horizontale Orientierung, wie es bei 60c in Fig. 2c dargestellt ist. Diese Tatsache wird bei der vorliegenden Erfindung ausgenutzt: Zur Feststellung des Fokussierungszustandes wird mittels des Stigmators 22 bewußt ein axialer Astigmatismus vorgegebener Orientierung eingeführt. Da die Orientierung des bewußt erzeugten axialen Astigmatismus dann bekannt ist, läßt sich nun aufgrund der Orientierung des Bildes der Autokorrelationsfunktion sofort feststellen, ob überfokussierung oder Unterfokussierung oder exakte Fokussierung vorliegt.

Das Vorzeichen einer etwaigen Defokussierung kann im einfachsten Falle optisch ermittelt werden, indem man in der Brennebene der Linse 50 eine Mattscheibe anordnet und das auf dieser entstehende optische Bild der Autokorrelationsfunktion betrachtet. Vorzugsweise erfolgt die Ermittlung des Fokussierungszustandes jedoch auf elektronischem wege, was u. a. den Vorteil hat, dan man die auf diese Weise erzeugten Signale für eine automatische Fokussierung des Elektronenmikroskops verwenden kann.

Zur elektronischen Ermittlung des Fokussierungszustandes kann man sich einer Photodiodenmatrix 62 der in Fig. 2 dargestellten Art bedienen, die in der Praxis jedoch im allgemeinen mehr als 3 x 3 Photodioden oder andere photoelektrische Aufnehmer enthalten wird. Die Signale der Photodioden 1 bis 9 lassen sich beispielsweise durch ein logisches Schaltnetz verarbeiten, wie es in Fig. 3 dargestellt ist. Zur Ermittlung des Zustandes "Überfokussierung" (+) und "Unterfokussierung" (-) dient jeweils eine Schaltungsanordnung der in Fig. 3a dargestellten Art. Die Bezeichnungen ohne Klammern gelten dabei für die Schaltung zur Ermittlung des Zustandes "Überfokussierung", die Bezeichnungen mit Klammern für die Schaltung zur Ermittlung des Zustandes "Unterfokussierung". Einem ersten UND-Glied, 70 werden die Signale von den drei Photodioden 2, 5, 8 (bzw. 4, 5, 6) zugeführt, aui die jeweils das längliche Bild 60b (bzw. 60c) der Autokorrelationsfunktion für den betreffenden Defokussierungszustand fällt. Zur Sicherheit kann noch eine Antikoinzidenzschaltung mit einem NOR-Glied 72 und einem zweiten UND-Glied 74 vorgesehen sein, die die Erzeugung des betreffenden Ausgangssignals nur dann zuläßt, wenn die seitlich der Mitte des strichförmigen Bildes liegenden Photodioden 4, 6 (bzw. 2, 8) kein Licht erhalten. Ein Signal F, das dem Zustand genauer Fokussierung entspricht, kann gemäß Fig. 3b durch ein Schaltnetz erzeugt werden, das ein NOR-Glied 76 mit vier Eingängen, die mit den rechts und links bzw. oberhalb und unterhalb der mittleren Photodiode 5 gelegenen Photodioden 2, 4, 6, 8 gekoppelt sind und dessen Ausgang mit einem ersten Eingang eines UND-Gliedes 78 verbunden ist, dessen zweiter Eingang mit der mittleren Photodiode 5 verbunden ist. Das UND-Glied 78 liefert das Ausgangssignal F also nur dann, wenn nur die Photodiode 5 Licht erhält, aber keine der Photodioden 2, 4, 6 und 8.

Die Länge des strichförmigen Bildes 60b, 60c hängt außer vom Betrag des Astigmatismus des Bildes auch vom Ausmaß der Defokussierung ab. Mit einer größeren oder feiner unterteilten Photodiodenmatrix kann also zusätzlich zum Vorzeichen der Defokussierung auch das Ausmaß der Defokussierung bestimmt werden.

Eine Grob- und eine Feineinstellung der Fokussierung läßt sich auf einfache Weise durchführen, indem man zuerst zur Grob-Fokussierung mittels des Stigmators 22 nur einen schwachen axialen Astigmatismus einführt, das Bild dann so weit fokussiert, wie es das Auflösungsvermögen des Korrelators 38 zuläßt und anschließend mittels des Stigmators 22 einen stärkeren Astigmatismus einstellt, so daß der Korrelator 38 erneut ansprechen und zur Nachfokussierung verwendet werden kann. Selbstverständlich kann man die Fokussierung auch in mehr als zwei Stufen durchführen.

Das in der Brennebene der Linse 50 erzeugte Bild der Autokorrelationsfunktion känn selbstverständlich auch auf andere Weise verarbeitet werden. Man kann es z. B. mittels einer Fernsehaufnahmeröhre aufnehmen, quantisieren und in einem Computer verarbeiten, wobei im Prinzip die gleichen Operationen durchgeführt werden, wie sie anhand der Figuren 2 und 3 erläutert wurden.

Die mit den logischen Schaltnetzen gemäß Fig. 3 erzeugten Signale lassen sich zur automatischen Scharfeinstellung des Elektronenmikroskops 10 verwenden. Zu diesem Zweck kann beispielsweise eine Programmsteuerung 80 vorgesehen sein, die in bestimmten gegebenenfalls einstellbaren Zeitabständen jeweils eine Überprüfung und gegebenenfalls Nachstellung des Fokussierungszustandes des Elektronenmikroskops 10 bewirkt. Zur Einleitung eines Überprüfungs- und Nachfokussierungsvorganges liefert die Programmsteuerung 80 als erstes ein Signal A an die Stromversorgung 24a für den Stigmator 22, durch das ein bestimmter Astigmatismus eingestellt wird. Anschließend liefert die Programmsteuerung 80 das Startsignal S an den Zähler 56, wodurch in der oben beschriebenen Weise die Eingabe eines Bildes in den optischen Korrelator 38 veranlaßt wird. Wenn die Logikschaltungen (Fig. 3a, Fig. 3b) in der Einrichtung 52 dann das Signal F liefern, ist das Elektronenmikroskop ordnungsgemäß fokussiert, die Programmsteuerung 80 stellt dann den Stigmator wieder zurück und schaltet ab, bis der Zeitpunkt für die nächste Nachprüfung des Fokussierungszustandes gekommen ist. Tritt jedoch das Signal (+) oder (-) auf, so liefert die Programmsteuerung 80 ein Nachstellsignal N ensprechenden Vorzeichens an den Stromversorgungsteil 24b, für das Objektiv 16, durch das der Objektivstrom im Sinne einer Verringerung der Defokussierung nachgestellt wird. Die Nachstellung kann iterativ erfolgen, d. h. der Strom wird um ein vorgegebenes, kleines Inkrement geändert, dann wird ein neuer Startimpuls S erzeugt und der Fokussierungszustand erneut überprüft. Alternativ kann die Verstellung des Objektivstroms stetig, aber so langsam erfolgen, daß die Änderung des Fokussierungszustandes kontinuierlich überprüft werden kann, indem eine Folge von Startimpulsen erzeugt wird, bis schlienlich das Signal F auftritt. Die Programmsteuerung 80 schaltet dann den Stigmator 22 wieder auf den normalen Zustand, in dem ein hinsichtlich des Astigmatismus optimal korrigiertes Bild erzeugt wird, zurück und geht in den Ruhezustand, bis der nächste Überprüfungs- und Fokussierungsvorgang gewünscht wird.

Anstelle der oben erwähnten optischen Korrelationscomputer kann man im vorliegenden Falle auch einen Digitalrechner verwenden, da zum Ermitteln des Fokussierungszustands nur relativ wenige Werte der Autokorrelationsfunktion in der Umgebung des Korrelationspeaks errechnet zu werden brauchen.

Die obigen Überlegungen lassen sich auch auf abbildende lichtoptische Geräte, wie Licht-Mikroskope, anwenden. Hier kann der erforderliche Astigmatismus z. B. durch Einführung einer Zylinderlinse in den Strahlengang des optischen Mikroskopes erfolgen. Die Zylinderlinse ist z. B. durch eine Schwenkvorrichtung oder eine elektromagnetische Antriebsvorrichtung (vom Objekt aus gesehen) hinter dem Objektiv und vor dem durch dieses erzeugte Zwischenbild selektiv in den Strahlengang einschaltbar gehalten.

**Patentansprüche**

1. Verfahren zum Ermitteln des Fokussierungszustandes eines teilchenoptischen bilderzeugenden Gerätes, wie eines Elektronenmikroskops, dessen Strahlengang eine Vorrichtung zur Beeinflussung des axialen Astigmatismus des erzeugten Bildes enthält, dadurch gekennzeichnet,
- daß damit ein axialer Astigmatismus vorgegebener Orientierung erzeugt wird;
- daß die in zwei verschiedenen Bildebenen entstehenden astigmatischen Bilder in zeitabhängige Signale umgewandelt und anschließend diese Signale direkt oder durch Umwandlung in optische Muster und anschließende optische Korrelation unter Erzeugung einer zweidimensionalen Korrelationsfunktion korreliert werden und

- daß die Orientierung der Korrelationsfunktion bestimmt wird.

2. Verfahren zum Ermitteln des Fokussierungszustandes eines lichtoptischen bilderzeugenden Gerätes, wie eines Lichtmikrokops,
dadurch gekennzeichnet,
- daß eine Vorrichtung zur Beeinflussung des axialen Astigmatismus des erzeugten Bildes vorgesehen ist,
- daß damit ein axialer Astigmatismus vorgegebener Orientierung erzeugt wird,
- daß die in zwei verschiedenen Bildebenen entstehenden astigmatischen Bilder in zeitabhängige Signale umgewandlt und anschließend diese Signale direkt oder durch Umwandlung in optische Muster und anschliesende optische Korrelation unter Erzeugung einer zweidimensionalen Korrelationsfunktion korreliert werden, und
- daß die Orientierung der Korrelationsfunktion bestimmt wird.

3. Verfahren nach Anspruch 1 oder 2, dadurch gekennzeichnet, daß die beiden astigmatischen Bilder gleich sind und unter Bildung der Autokorrelationsfunktion korreliert werden.

4. Verfahren nach Anspruch 1 oder 2, dadurch gekennzeichnet, daß ein bestimmter Betrag des Astigmatismus eingestellt wird und daß der Betrag der Defokussierung aus der Längsabmessung des aus der Korrelationsfunktion resultierenden Korrelations-Peaks bestimmt wird.

5. Teilchenoptische Einrichtung, wie Elektronenmikroskop, zur Durchführung des Verfahrens nach Anspruch 1 mit einem Abbildungssystem, welches eine Soll-Bildebene und eine Vorrichtung zur Beeinflussung des axialen Astigmatismus eines in der Soll-Bildebene erzeugten Bildes enthält, und mit einer Korrelationsvorrichtung (38) eine Anordnung (62, 70) zum Ermitteln der Orientierung eines länglichen Korrelations-Peaks enthält.

6. Lichtoptische Einrichtung zur Durchführung des Verfahrens nach Anspruch 2 mit einem Abbildungssystem zum Erzeugen eines Bildes in einer Soll-Bildebene und mit einer Korrelationsvorrichtung, der eine dem Bild entsprechende Eingangsgröße zugeführt ist, um einen Korrelations-Peak zu erzeugen, dadurch gekennzeichnet,
- daß das Abbildungssystem eine Vorrichtung zur Beeinflussung des axialen Astigmatismus des erzeugten Bildes enthält und
- daß die Korrelationsvorrichtung (38) eine Anordnung (62, 70) zum Ermitteln der Orientierung des infolge des eingeführten Astigmatismus länglichen Korrelations-Peaks enthält.

7. Einrichtung nach Anspruch 5 oder 6, dadurch gekennzeichnet, daß die Korrelationsvorrichtung (38) eine Autokorrelationsvorrichtung ist.

8. Einrichtung nach Anspruch 5, 6 oder 7, dadurch gekennzeichnet, daß die Korrelationsvorrichtung (38) ein optischer Korrelator ist.

9. Einrichtung nach Anspruch 8, dadurch gekennzeichnet, daß der optische Korrelator Flüssigkristallmatrixanordnungen (42, 44 zum Erzeugen optischer Darstellungen des Bildes enthält.

10. Einrichtung nach einem der Ansprüche 5 bis 9, gekennzeichnet durch eine Steuervorrichtung (80), die bei Auslösung einen vorgegebenen axialen Astigmatismus bestimmter Orientierung erzeugt und anschließend die Ermittlung der Orientierung des Korrelations-Peaks veranlaßt.

11. Einrichtung nach Anspruch 10, dadurch gekennzeichnet, daß ein der Orientierung des Korrelations-Peaks entsprechendes Signal einer Vorrichtung zur Nachstellung des Fokussierungszustandes zugeführt ist.


**Claims**

1. Process for determining the focusing state of a particle-optical imaging device, such as an electron microscope, whose beam path includes a device for influencing the axial astigmatism of the image produced,
characterised in that,
- an axial astigmatism of predetermined orientation is produced with it;
- the astigmatic images produced in two different image planes are converted into time-dependent signals and these signals are subsequently correlated directly or by conversion into optical patterns and subsequent optical correlation whilst producing a two-dimensional correlation function and
- the orientation of the correlation function is determined.

2. Process for determining the focusing state of a light-optical imaging device, such as an optical microscope,
characterised in that,
- a device is provided for influencing the axial astigmatism of the image produced,
- that an axial astigmatism of predetermined orientation is produced with it,
- the astigmatic images produced in two different image planes are converted into time-dependent signals and these signals are subsequently correlated directly or by conversion into optical patterns and subsequent optical correlation whilst producing a two-dimensional correlation function, and
- the orientation of the correlation function is determined.

3. Process as claimed in claim 1 or 2, characterised in that the two astigmatic images are the same and are correlated by forming the auto-correlation function.

4. Process as claimed in claim 1 or 2, characterised in that a predetermined amount of the astigmatism is set and that the amount of the defocusing from the longitudinal dimension of the correlation peak resulting from the correlation function is determined.

5. Particle-optical apparatus, such as an electron microscope, for carrying out the process as claimed in claim 1 with an imaging system which includes a desired image plane and a device for influencing the axial astigmatism of an image produced in the desired image plane and with a correlation device to which an input parameter corresponding to the image is supplied, characterised in that the correlation device (38) includes an arrangement (62, 70) for determining the orientation of an elongate correlation peak.

6. Light-optical apparatus for carrying out the process as claimed in claim 2 with an imaging system for producing an image in a desired image plane and with a correlation device to which an input parameter corresponding to the image is supplied in order to produce a correlation peak, characterised in that,
- the imaging system includes a device for influencing the axial astigmatism of the image produced and,
- the correlation device (38) includes an arrangement (62, 70) for determining the orientation of the correlation peak which is elongated as a consequence of the astigmatism introduced.

7. Apparatus as claimed in claim 5 or 6, characterised in that the correlation device (38) is an auto-correlation device.

8. Apparatus as claimed in claim 5, 6 or 7, characterised in that the correlation device (38) is an optical correlator.

9. Apparatus as claimed in claim 8, characterised in that the optical correlator includes liquid crystal matrix arrangements (42, 44) for producing optical representations of the image.

10. Apparatus as claimed in one of claims 5 to 9, characterised by a control device (80) which, when rendered operative, produces a predetermined axial astigmatism of predetermined orientation and subsequently causes the determination of the orientation of the correlation peak.

11. Apparatus as claimed in claim 10, characterised in that a signal corresponding to the orientation of the correlation peak is supplied to a device for adjusting the focusing state.

**Revendications**

1. Procédé pour déterminer la focalisation d'un appareil optique à particules produisant des images, tels qu'un microscope électronique, dont la marche des rayons contient un dispositif pour influencer l'astigmatisme axial de l'image produite, caractérisé en ce que
- on produit ainsi un astigmatisme axial d'une orientation prédéterminée,
- les images astigmatiques produites dans deux plans d'images différents sont transformées en signaux fonction du temps, puis ces signaux sont directement corrélés en produisant une fonction de corrélation bidimensionnelle, ou par transformation en modèle optique suivie d'une corrélation optique, et
- on détermine l'orientation de la fonction de corrélation.

2. Procédé pour déterminer l'état de focalisation d'un appareil optique produisant des images, tel qu'un microscope optique, caractérisé en ce que
- on prévoit un dispositif pour influencer l'astigmatisme axial de l'image produite,
- les images astigmatiques se produisant dans deux plans d'images différents sont transformées en signaux fonction du temps, et ces signaux sont ensuite corrélés directement en produisant une fonction de corrélation bidimensionnelle, ou par transformation en modèle optique suivie d'une corrélation optique, et
- on détermine l'orientation de la fonction de corrélation.

3. Procédé selon la revendication 1 ou 2, caractérisé en ce que les deux images astigmatiques sont identiques et sont corrélées en formant la fonction d'autocorrélation.

4. Procédé selon la revendication 1 ou 2, caractérisé en ce qu'on règle une valeur déterminée de l'astigmatisme, et en ce que la valeur de la défocalisation est déterminée à partir d'un pic de corrélation résultant de la fonction de corrélation.

5. Dispositif d'optique des particules, tel que microscope électronique, pour mettre en oeuvre le procédé selon la revendication 1 comportant un système de représentation qui contient un plan d'images théoriques et un dispositif pour influencer l'astigmatisme axial d'une image produite dans le plan d'images théoriques, et un dispositif de corrélation auquel est amenée une grandeur d'entrée correspondant à l'image, caractérisé en ce que le dispositif de corrélation (38) comporte un agencement (62, 70) pour déterminer l'orientation d'un pic de corrélation longitudinal.

6. Dispositif optique pour mettre en oeuvre le procédé selon la revendication 2, comportant un système de représentation pour produire une image dans un plan d'images théoriques, et un dispositif de corrélation auquel est amenée une grandeur d'entrée correspondant à l'image, pour produire un pic de corrélation, caractérisé en ce que
- le système de représentation contient un dispositif pour influencer l'astigmatisme axial de l'image produite, et
- le dispositif de corrélation (38) contient un agencement (62, 70) pour déterminer l'orientation du pic de corrélation longitudinal dû à l'introduction de l'astigmatisme.

7. Dispositif selon la revendication 5 ou 6, caractérisé en ce que le dispositif de corrélation (38) et un dispositif d'auto-corrélation.

8. Dispositif selon la revendication 5, 6 ou 7, caractérisé en ce que le dispositif de corrélation (38) est un corrélateur optique.

9. Dispositif selon la revendication 8, caractérisé en ce que le corrélateur optique contient de agencements de matrice à cristaux liquides (42, 44) pour produire des représentations optiques de l'image.

10. Dispositif selon l'une des revendications 5 à 9, caractérisé par un dispositif de commande (80) qui lors du déclenchement, produit un astigmatisme axial prédéterminé d'une orientation déterminée et déclenche ensuite la détermination de l'orientation du pic de corrélation.

11. Dispositif selon la revendication 10, caractérisé en ce qu'un signal correspondant à l'orientation du pic de corrélation est amené à un dispositif pour rajuster l'état de focalisation.

FIG.1

FIG.2

FIG.3a

FIG.3b